# EUROPÄISCHE PATENTSCHRIFT

(11) **EP 0 502 500 B1**
(45) Veröffentlichungstag und Bekanntmachung des Hinweises auf die Patenterteilung: **29.12.1997**
(21) Anmeldenummer: 92103685.1
(22) Anmeldetag: 04.03.1992
(51) Int. Cl.: H03J 1/00

(54) **Verfahren zur Abstimmung eines Rundfunkempfängers unter Ausnutzung der RDS-Informationen**
Method for tuning of a radio receiver, using RDS-data
Méthode pour l'accord d'un récepteur radio, utilisant des information RDS

(30) Priorität: 04.03.1991 DE 4106852
(43) Veröffentlichungstag der Anmeldung: 09.09.1992
(73) Patentinhaber: BECKER GmbH, D-76307 Karlsbad (DE)
(72) Erfinder: Rupprecht, Matthias, W-7541 Straubenhardt (DE); Schmidt, Willy, W-7500 Karlsruhe 41 (DE); Trinks, Wolfgang, W-7500 Karlsruhe 1 (DE)
(74) Vertreter: Degwert, Hartmut, Dipl.-Phys.

(56) Entgegenhaltungen:
- EP-A- 0 211 366
- EP-A- 0 403 744
- WO-A-91/03102

## Beschreibung

Die Erfindung betrifft ein Verfahren zur Abstimmung eines mikrocomputergesteuerten Rundfunkempfängers auf denjenigen unter mehreren dasselbe Programm ausstrahlenden Sendern, welcher die besten Empfangsqualitätsvoraussetzungen erfüllt, gemäß dem Oberbegriff des Anspruchs 1, unter Ausnutzung der RDS-Informationen und vorzugsweise unter Verwendung nur eines Empfangsteils. Das erfindungsgemäße Verfahren ist besonders zur Anwendung bei mobilen Rundfunkempfängern bestimmt, insbesondere Autoradios.

Seit der Verfügbarkeit der RDS-Informationen ist es möglich geworden, auch Rundfunkempfänger mit nur einem Empfangsteil auf denjenigen unter mehreren, dasselbe Programm ausstrahlenden Sendern, der die besten Empfangsqualitätsvoraussetzungen erfüllt, automatisch einzustellen. Die RDS-Informationen erleichtern aber auch die Verwirklichung von Rundfunkempfängern mit zwei Empfangsteilen, von denen eines ständig mit der Prüfung der in den RDS-Informationen vermittelten Alternativsenderfrequenzen befaßt ist.

Um nun unter den im RDS-Datenstrom genannten Alternativsenderfrequenzen diejenige auswählen zu können, die tatsächlich zu der besten Empfangsqualität führt, muß jede einzelne Alternativsenderfrequenz geprüft werden. Da zu dem jeweils eingestellten Sender bis zu 40 Alternativsenderfrequenzen genannt werden können, erfordert die Überprüfung aller Frequenzen eine Zeitspanne von erheblicher Dauer. Zwar kann die Empfangsqualität eines Senders anhand der Feldstärke und anderer Signale, die das Auftreten von Empfangsstörungen anzeigen (Mehrwege-, Nachbarkanal- und Gleichkanal-Empfangsstörungen), relativ schnell gemessen werden, jedoch erfordert die Bestimmung des Identitätscodes eines zur Überprüfung eingestellten Senders einen Zeitraum von bis zu 1 Sekunde. Die Überprüfung der Identitätscodes ist aber notwendig, da wegen unvorhersehbarer Überschneidungen von Empfangsgebieten Mehrdeutigkeiten auftreten können. Aufgrund von besonderen Empfangsverhältnissen kann unter einer gegebenen Frequenz, die im RDS-Datenstrom enthalten ist, durchaus ein Programm empfangen werden, das von dem des gerade eingestellten Senders, dessen Alternativfrequenzen im Datenstrom aufgeführt sind, verschieden ist.

Da somit die Überprüfung der Empfangsqualität und des Identitätscodes aller im RDS-Datenstrom aufgeführten Alternativfrequenzen eine erhebliche Zeitspanne erfordert, besteht besonders bei mobilen Rundfunkempfängern das Problem, daß die bei der Prüfung über die Alternativsender gewonnenen Informationen in dem Moment, wo eine Abstimmung auf einen Alternativsender erfolgen muß, weil die Empfangsqualität des aktuell eingestellten Senders nachläßt, unter Umständen nicht mehr aktuell sind. Dieses Problem ist besonders gravierend bei Rundfunkempfängern mit nur einem Empfangsteil, da dieses jeweils nur sehr kurzzeitig auf eine Alternativfrequenz eingestellt werden darf, damit diese Umschaltung nicht störend in Erscheinung tritt. Eine Überprüfung des Identitätscodes ist nur möglich, wenn der Empfänger während einer Zeitspanne von mindestens einigen hundert Millisekunden auf die Alternativfrequenz eingestellt bleibt, was voraussetzt, daß die Empfangsqualität ausreicht.

Durch die Erfindung mit den Merkmalen des Anspruchs 1 wird ein Verfahren zur Abstimmung eines mikrocomputergesteuerten Rundfunkempfängers unter Ausnutzung der RDS-Informationen geschaffen, das sowohl bei Zweiempfänger- als auch bei Einempfänger-Konzepten anwendbar ist, dessen Vorzüge aber besonders bei Empfängern mit nur einem Empfangsteil und bei mobilen Empfängern zum Tragen kommen. Die Erfindung geht von der Erkenntnis aus, daß die Wahrscheinlichkeit, bei einer Abstimmung auf eine der im RDS-Datenstrom genannten Alternativfrequenzen diejenige auszuwählen, die tatsächlich die besten Empfangsqualtitätsvoraussetzungen erfüllt, erheblich gesteigert werden kann, wenn eine dynamische Verwaltung der festgestellten Qualitätsbewertungs-Informationen und Identitätscodes erfolgt. Die aus dem RDS-Datenstrom gewonnenen Daten werden zunächst in einer Alternativsender-Tabelle abgespeichert. Sobald eine Abstimmung auf einen Sender erfolgt, dessen Frequenz in dieser Tabelle gespeichert ist, wird eine Qualitätsbewertungs-Information in Zuordnung zu dieser Frequenz abgespeichert. Bei der Abstimmung auf eine der Alternativfrequenzen der Tabelle wird die sich aus der jeweils zugehörigen, abgespeicherten Qualitätsbewertungs-Information ergebende Rangfolge berücksichtigt. Diese Rangfolge ist jedoch in ständiger Entwicklung. Zu jeder Alternativfrequenz wird in der Alternativsender-Tabelle eine Aktualitäts-Information gespeichert, die das Maß der Aktualität der zu dieser Alternativfrequenz verfügbaren Informationen wiedergibt, insbesondere die Qualitätsbewertungs-Information und die Identitätsinformation. Bei der Bestimmung der Rangfolge in der Alternativsender-Tabelle wird die Aktualitäts-Information mitberücksichtigt. Beispielsweise kann eine in der Tabelle gespeicherte Alternativfrequenz, zu der zu einem gegebenen Zeitpunkt eine gute Empfangsqualität und ein zutreffender Identitätscode gemessen wurde, nach einigen Minuten in der Rangfolge unter eine Alternativfrequenz absinken, zu der eine geringere Empfangsqualität gemessen wurde, wenn diese Messung noch aktuell ist, also erst vor einigen Sekunden erfolgte.

Bei der Auswahl unter den in der Tabelle gespeicherten Alternativfrequenzen kommt dem Identitätscode eine besondere Bedeutung zu. Eine Umschaltung auf einen Sender, der ein unzutreffendes Programm ausstrahlt, soll möglichst vermieden werden. Andererseits wird gerade für die Gewinnung des Identitätscodes zu den einzelnen Alternativfrequenzen besonders viel Zeit benötigt. Gemäß einer besonderen Ausführungsform der Erfindung wird daher in der Alternativsender-Tabelle eine Auswahl getroffen, indem wenigstens zwei Gruppen gebildet werden, wovon die erste die in der Rangfolge höherliegenden Alternativfrequenzen beinhaltet, deren Identitätscode bei einer Prüfung als zutreffend erkannt wurde. Alle Alternativfrequenzen, zu denen kein Identitätscode bekannt ist oder bei denen sogar ein falscher Identitätscode festgestellt wurde, werden in der Rangfolge niedriger eingestuft, auch wenn die zugehörige, gemessene Qualitätsbewertungsinformation eine gute Empfangsqualität erwarten läßt. Auch bei der Zuordnung der Alternativfrequenzen zu den Gruppen der Alternativsender-Tabelle wird vorzugsweise die Aktualitäts-Information berücksichtigt. Die Zugehörigkeit zu der in der Rangfolge am höchsten liegenden Gruppe ist also nicht nur davon abhängig, daß der Identitätscode als zutreffend erkannt wurde, die diesbezügliche Information muß auch noch aktuell sein. Wenn seit der Feststellung des zutreffenden Identitätscodes bereits beispielsweise 10 Minuten vergangen sind, wird diese Information als veraltet angesehen, und die betreffende Alternativfrequenz wird aus der ersten Gruppe entfernt und in einer niedrigeren Gruppe einsortiert.

Um besonders bei Rundfunkempfängern mit nur einem Empfangsteil die Häufigkeit der Umschaltungen zu minimieren, wird die Prüfung der Alternativfrequenzen aus der Alternativsender-Tabelle auf die erste Gruppe beschränkt, wenn der gerade eingestellte Sender eine vorbestimmte Mindest-Empfangsqualität aufweist. Es ist dann relativ unwahrscheinlich, daß eine der Alternativfrequenzen aus einer anderen Gruppe eine bessere Empfangsqualität ergibt und einen zutreffenden Identitätscode aufweist.

Bei den in der ersten Gruppe enthaltenen Alternativfrequenzen ist der Identitätscode sehr zuverlässig. Eine Weiterbildung der Erfindung besteht daher darin, daß bei einer Umschaltung auf eine der Alternativfrequenzen in der ersten Gruppe keine Prüfung des Identitätscodes vorgenommen werden muß. Wenn auf eine Überprüfung des Identitätscodes verzichtet werden kann, ist es möglich, die in der ersten Gruppe enthaltenen Alternativfrequenzen sehr viel häufiger zu prüfen, da die Messung der Empfangsqualität sehr schnell erfolgen kann und im Hörbetrieb kaum als störend empfunden wird.

Bei Abstimmung auf eine Alternativfrequenz, zu der keine gesicherte Information über den Identitätscode verfügbar ist, soll eine Stummschaltung erfolgen, um zu gewährleisten, daß kein unerwünschtes Programm zu Gehör gebracht wird. Ein besonderer Aspekt der Erfindung besteht nun darin, daß bei einer Umschaltung auf eine der Alternativfrequenzen, für die ein gesicherter Identitätscode verfügbar ist, keine Stummschaltung während der Überprüfung des Identitätscodes vorgenommen wird. Auf diese Weise werden häufige, durch Stummschaltung bedingte Unterbrechungen des Hörbetriebs vermieden. Da in der ersten Gruppe von Alternativfrequenzen nur solche aufgeführt sind, für die eine sichere und noch aktuelle Information über den Identitätscode verfügbar ist, wird bei jeder Umschaltung auf eine Alternativfrequenz der ersten Gruppe auf eine Stummschaltung während der Prüfung des Identitätscodes verzichtet.

Jede Umschaltung von der aktuell eingestellten Empfangsfrequenz auf eine der Alternativfrequenzen verursacht eine - wenn auch geringfügige - Unterbrechung des Hörbetriebs. Es ist daher anzustreben, möglichst wenige Umschaltungen auf Alternativfrequenzen durchzuführen. Andererseits sollte vermieden werden, daß eine Alternativfrequenz, die eine deutlich bessere Empfangsfrequenz ergeben würde als die aktuelle Empfangsfrequenz, nicht geprüft wird, weil die Empfangsqualität der aktuellen Sendefrequenz noch akzeptabel ist. Gemäß einer Weiterbildung der Erfindung wird daher vorgeschlagen, daß eine Überprüfung der aktuell eingestellten Senderfrequenz auf beste Empfangsqualität durch Vergleich mit den Alternativfrequenzen davon abhängig ist, daß die aktuell gemessene Qualitätsbewertungs-Information einen Schwellwert unterschreitet, der auf folgende Weise gebildet wird:
a) bei einer Einstellung auf diese aktuelle Senderfrequenz wird die gemessene Qualitätsbewertungs-Information über eine gegebene Zeitspanne gemittelt;
b) der so erhaltene Mittelwert wird um eine vorbestimmte Größe vermindert;
c) der so verminderte Mittelwert bildet den Schwellwert, der anschließend mit der abgelaufenen Zeit wieder erhöht wird und nach einigen Minuten wieder den unverminderten Mittelwert erreichen kann.

Jede Einstellung auf eine bestimmte Senderfrequenz, die zum Zeitpunkt der Einstellung die bestmögliche Empfangsqualität ergibt, wird als vorläufig angesehen. Der Schwellwert wird anfangs um eine vorbestimmte Größe niedriger angesetzt als der gemessene Mittelwert der Qualitätsbewertungs-Information. Auf diese Weise wird erreicht, daß nicht unmittelbar nach der Einstellung auf eine bestimmte Senderfrequenz eine erneute Überprüfung anderer Alternativfrequenzen erfolgt. Der Schwellwert steigt aber nun mit der Zeit kontinuierlich an. Die Qualitätsbewertungs-Information, die laufend gemessen wird, wird mit dem Schwellwert verglichen. Die Empfangsqualität kann nun gleich bleiben, besser oder auch schlechter werden. Wenn sie unter den Schwellwert absinkt, könnte eine Umschaltung auf eine andere Alternativfrequenz erfolgen. Vorzugsweise wird diese Umschaltung aber erst freigegeben, wenn ein weiteres Kriterium erfüllt ist, nämlich dann, wenn eine momentane Störung der Empfangsqualität festgestellt wird. Besonders geeignet sind Störungen durch Mehrwege-Empfang, die zu einem kurzzeitigen Qualitätseinbruch führen. Die damit verbundene Empfangsstörung kann ausgenutzt werden, um auf eine Alternativfrequenz umzuschalten. Wenn der Identitätscode der Alternativfrequenz, auf die umgeschaltet wird, bekannt und noch aktuell ist, erfolgt keine Stummschaltung während der Überprüfung des Identitätscodes, so daß - wenn die Empfangsqualität der betreffenden Alternativfrequenz ausreicht - weder die Empfangsstörung, noch die Umschaltung im Hörbetrieb subjektiv störend in Erscheinung tritt.

Besonders zweckmäßig ist es, wenn die Erhöhung des Schwellwertes mit der Zeit um so schneller erfolgt, desto höher die Empfangsqualität des aktuell eingestellten Senders ist. Auf diese Weise wird vermieden, daß ein Sender, der mit relativ guter Empfangsqualität empfangen wird, über längere Zeit die Einstellung auf eine Alternativfrequenz verhindert, die eine noch bessere Empfangsqualität ergeben würde.

Um nach jeder Umschaltung auf eine Alternativfrequenz optimale Voraussetzungen für die darauffolgende Überprüfung der nächsten Alternativfrequenz zu schaffen, ist weiterhin vorgesehen, daß nach jeder Überprüfung eine neue Rangfolge der Alternativfrequenzen ermittelt wird und diese Alternativfrequenzen in der Alternativsender-Tabelle gemäß der neuen Reihenfolge einsortiert werden. Im Regelfall ergibt dann stets die Überprüfung nur einer Alternativfrequenz in der Tabelle, nämlich der Alternativfrequenz mit dem höchsten Rang in der Tabelle, die nach den Umständen bestmögliche Empfangsqualität. Außer der ersten Gruppe von Alternativfrequenzen, deren Identitätscode bekannt, richtig und auch noch aktuell ist, werden vorzugsweise zwei weitere Gruppen gebildet, nämlich eine zweite Gruppe mit denjenigen Alternativfrequenzen, deren Identitätscode unbekannt ist oder deren Identitätscode zwar als falsch oder richtig erkannt wurde, aber aufgrund der Aktualitäts-Information als veraltet angesehen wird, und eine dritte Gruppe mit denjenigen Alternativfrequenzen, deren Identitätscode als falsch erkannt wurde und aufgrund der Aktualitäts-Information nicht als veraltet angesehen wird. Die zweite Gruppe wird in der Rangfolge höher eingestuft als die dritte Gruppe.

Weitere Merkmale und Vorteile der Erfindung ergeben sich aus der folgenden Beschreibung und aus der Zeichnung, auf die Bezug genommen wird. In der Zeichnung zeigen:
- Fig. 1: ein Blockschaltbild eines Rundfunkempfängers zur Durchführung des erfindungsgemäßen Verfahrens;
- Fig. 2: eine erste, bei dem Verfahren verwendete Tabelle;
- Fig. 3: eine zweite, bei dem Verfahren verwendete Tabelle;
- Fig. 4a bis 4d: Diagramme, die das Kriterium zur Umschaltung auf einen Alternativsender veranschaulichen; und
- Fig. 5a und 5b: ein Flußdiagramm, das die Prüfung einer Alternativfrequenz veranschaulicht.

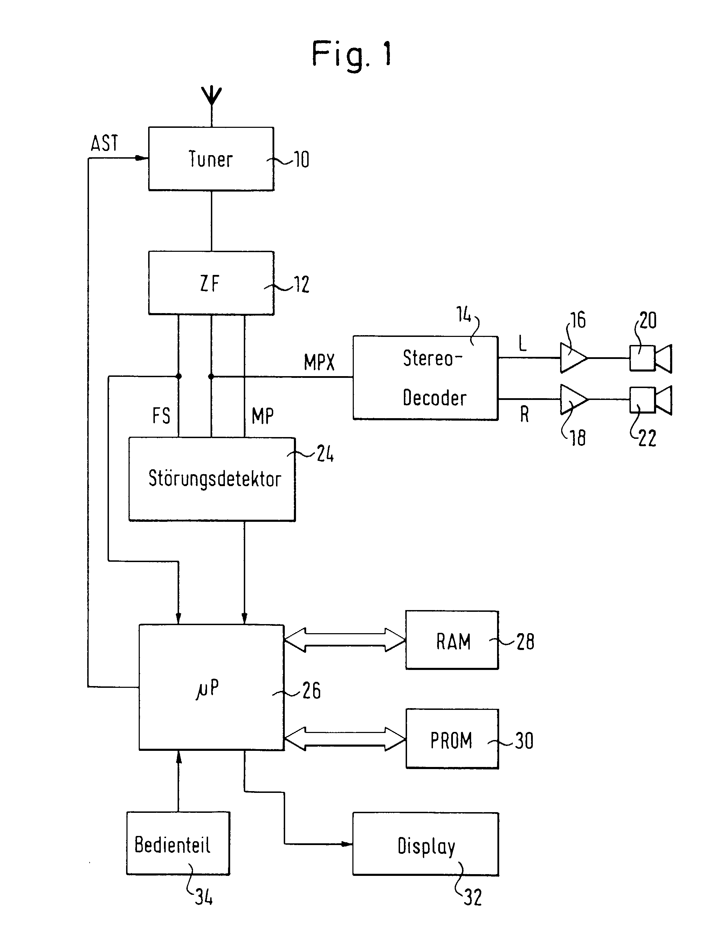

In herkömmlicher Weise enthält der in Fig. 1 dargestellte Rundfunkempfänger einen Tuner 10, an den das Antennensignal angelegt ist, einen Zwischenfrequenzteil 12, einen Stereodecoder 14, an dessen Eingang das MPX-Signal vom Ausgang des Zwischenfrequenzteils 12 angelegt ist, und Verstärkerstufen 16, 18 zur Ansteuerung von Lautsprechern 20, 22. An die Eingänge eines Störungsdetektors 24 sind außer dem MPX-Signal ein Feldstärkesignal FS und ein Signal MP angelegt, welches das Auftreten von Mehrwege-Empfangsstörungen signalisiert.

Zur Steuerung des Rundfunkempfängers ist ein Mikroprozessor 26 vorgesehen. Das Ausgangssignal ST des Störungsdetektors 24 und das Feldstärkesignal FS werden an den Mikroprozessor 26 angelegt. Der Mikroprozessor 26 gibt ein Abstimmsignal AST an den Tuner 10 aus. Durch einen Arbeitsspeicher 28 und einen programmierbaren Festwertspeicher 30 wird der Mikroprozessor 26 zu einem Mikrocomputer. Mit diesem Mikrocomputer verbunden sind ferner eine Anzeigeeinheit 32 und ein Bedienteil 34.

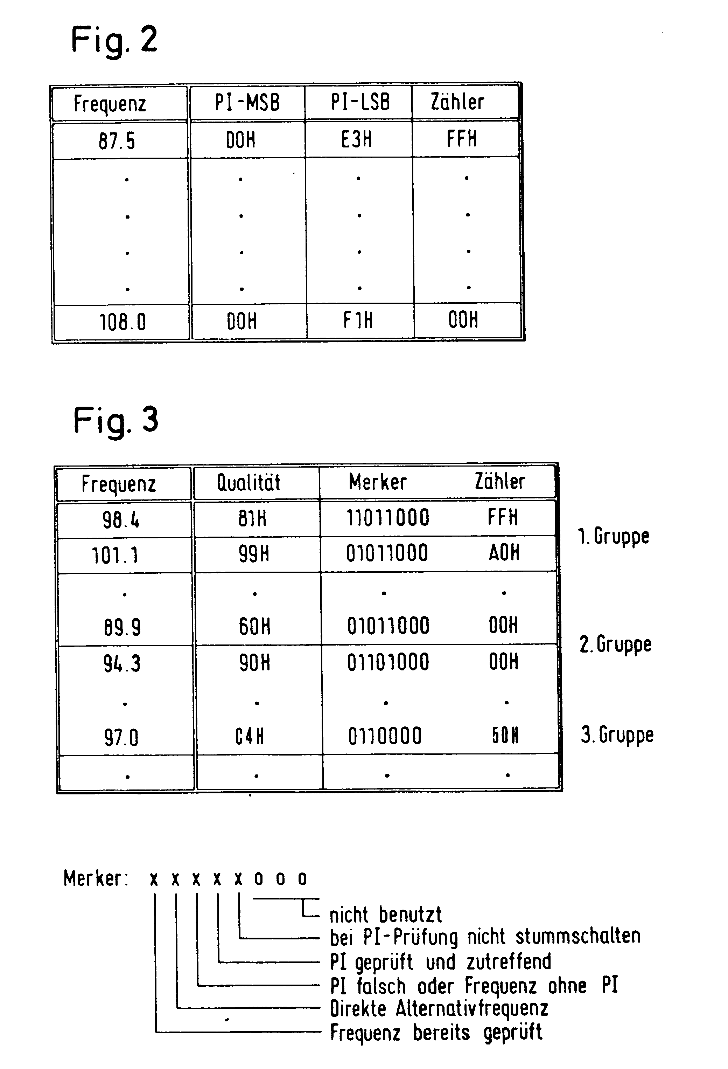

Zur Beschreibung des erfindungsgemäßen Verfahrens wird nun angenommen, daß der Rundfunkempfänger eingeschaltet wurde und noch keine Informationen über Alternativfrequenzen vorliegen. Sobald der Tuner 10, beispielsweise durch Betätigen einer Stationstaste am Bedienteil 34, auf das gewünschte Programm eingestellt wurde, werden neben dem Programm über eine Hilfsträgerfrequenz von 57 kHz kontinuierlich die RDS-Informationen als binärer Datenstrom empfangen. Dieser Datenstrom enthält unter anderem die Alternativfrequenzen (AF) zu der gerade eingestellten Empfangsfrequenz und den Identitätscode (PI) des aktuell eingestellten Senders. Der Identitätscode oder PI-Code des aktuell eingestellten Senders steht im allgemeinen einige hundert Millisekunden nach erstmaliger Einstellung auf die betreffende Empfangsfrequenz zur Verfügung. Die über den Datenstrom empfangenen Alternativfrequenzen werden nun bei dem erfindungsgemäßen Verfahren in einer ersten Tabelle abgespeichert, die in Fig. 2 dargestellt ist. Zu jeder Empfangsfrequenz wird zusätzlich der PI-Code gespeichert, soweit dieser verfügbar ist. Ferner wird jeder Alternativfrequenz, die in dieser ersten Tabelle gespeichert ist, ein Zähler zugeordnet, der bei der Feststellung eines PI-Codes mit einem vorbestimmten Anfangswert geladen und dann innerhalb einer Zeitspanne von etwa 10 Minuten kontinuierlich bis auf Null dekrementiert wird. Der Zählerstand jeder Alternativfrequenz ist somit ein Maß für die Aktualität der Identitätsinformation zu der betreffenden Alternativfrequenz. Wie aus Fig. 2 ersichtlich ist, werden in der ersten Tabelle die höherwertigen Bits MSB getrennt von den niederwertigen Bits LSB des PI-Codes gespeichert.

In der in Fig. 2 gezeigten, ersten Tabelle werden alle über den RDS-Datenstrom mitgeteilten Alternativfrequenzen zu der gerade eingestellten Empfangsfrequenz ohne Differenzierung nach der Empfangsqualität abgespeichert. Diese Tabelle wird im Arbeitsspeicher 28 des Mikrocomputers angelegt. Abweichend von derzeit üblichen Mikrocomputern wird vorzugsweise ein solcher mit relativ großem Arbeitsspeicher verwendet, da dann die Möglichkeit besteht, mehr Alternativfrequenzen als unbedingt notwendig in der Tabelle aufzubewahren. Kurz nach dem Einschalten des Rundfunkempfängers liegen zunächst nur der PI-Code des aktuell eingestellten Senders sowie einiger weiterer, nach dem Einschalten geprüfter Sender vor. Zu den anderen in der Tabelle aufgeführten Alternativfrequenzen wird der PI-Code gespeichert, sobald eine Abstimmung auf diese Frequenzen während einer ausreichend langen Zeitspanne erfolgte, um den PI-Code empfangen zu können.

Im Arbeitsspeicher 28 wird außer der in Fig. 2 gezeigten, ersten Tabelle eine weitere, in Fig. 3 gezeigte Tabelle gebildet. Diese in Fig. 3 gezeigte Tabelle, die eingangs als Alternativsender-Tabelle bezeichnet wurde, enthält zu jeder Alternativfrequenz, die in der ersten, in Fig. 2 gezeigten Tabelle gespeichert ist, drei weitere Einträge, nämlich:
a) eine Qualitätsbewertungs-Information;
b) einen Merker; und
c) einen Zähler.

Die Qualitätsbewertungs-Information wird als Differenz zwischen dem Feldstärkesignal FS und dem das Störungsmaß angebenden Signal ST gebildet. Zur Speicherung dieser Qualitätsbewertungs-Information wird ein Byte verwendet. Folglich können Werte zwischen FFH und 00H gespeichert werden. Die in dem Störungsdetektor 24 (Fig. 1) vorgenommene Qualitätsbewertung liefert in einem Analogsignal ein Maß für Feldstärke, Gleichkanal-, Nachbarkanal- und Mehrwegeempfangs-Störung. Zusätzlich wird ein Signal MP zur Verfügung gestellt, das in erster Linie ein Maß für die auftretenden Mehrwegeempfangsstörungen ist, in das aber auch starke Gleich- und Nebenkanalstörungen eingehen. Dieses Signal ist weitgehend feldstärkeunabhängig. Um die Hörqualität einer Frequenz bewerten zu können, wird das Qualitätssignal um das Mehrwege-Empfangsstörungssignal vermindert. Das Ergebnis wird als Qualitätsbewertungs-Information in der zweiten Tabelle, die in Fig. 3 gezeigt ist, abgespeichert.

Der Merker besteht aus acht einzelnen Bits, von denen die ersten fünf wie folgt belegt sind:
a) das erste Bit ist gesetzt, wenn bei der Prüfung des PI-Codes keine Stummschaltung erfolgen soll;
b) das zweite Bit ist gesetzt, wenn der PI-Code geprüft und als zutreffend befunden wurde;
c) das dritte Bit ist gesetzt, wenn der PI-Code als unzutreffend erkannt wurde oder keine Information über den PI-Code vorliegt;
d) das vierte Bit ist gesetzt, wenn die Frequenz eine Alternativfrequenz ist;
e) das fünfte Bit ist gesetzt, wenn die Frequenz bereits geprüft wurde.

Die drei restlichen Bits werden nicht benutzt und stehen für andere Zwecke zur Verfügung.

Wenn im Verlaufe des Betriebs des Rundfunkempfängers die Abstimmfrequenz geändert wird, so bleiben auch diejenigen Frequenzen, die zur aktuellen Abstimmfrequenz keine Alternative mehr darstellen, in der Tabelle enthalten; jedoch wird das vierte Bit des Merkers ("Alternativfrequenz") nicht gesetzt. Somit bleiben die Informationen (PI zutreffend bzw. unzutreffend) für andere Abstimmfrequenzen der Senderkette erhalten.

Bei jedem Versuch der Umschaltung auf eine der Alternativfrequenzen werden die zur aktuellen Abstimmfrequenz alternativen Frequenzen in der Alternativsender-Tabelle eingetragen, falls sie dort noch nicht gespeichert sind. Bei jedem Eintrag einer Frequenz wird der aktuelle PI-Code mit dem in der ersten, in Fig. 2 gezeigten Tabelle für diese Frequenz abgelegten PI-Code verglichen. Sind die PI-Codes verschieden, so wird das dritte Bit des Merkers gesetzt ("PI-Code unzutreffend"). Sind beide PI-Codes gleich und ist der zugehörige Zähler in der ersten Tabelle (Fig. 2) noch nicht vollständig heruntergezählt, so wird das zweite Bit ("PI-Code zutreffend") gesetzt.

Ist der Zähler aber schon auf Null heruntergezählt oder ist in der ersten Tabelle für die betreffende Frequenz noch kein PI-Code eingetragen, so wird keines der beiden Bits des Merkers gesetzt. Für diese Frequenz liegt dann keine gesicherte Information über ihren PI-Code vor.

Unabhängig vom Zählerstand wird, wenn die verglichenen Codes übereinstimmen, das erste Bit gesetzt, um beim nächsten Umschalten auf diese Frequenz keine Stummschaltung während der Überprüfung des PI-Codes durchzuführen.

Für jeden Frequenzeintrag wird in der Alternativsender-Tabelle ein Zähler vorgesehen, der alle 2 bis 3 Sekunden dekrementiert wird. Zur Optimierung der zeitlichen Verwaltung der Alternativsender-Tabelle kann bei einem mobilen Rundfunkempfänger (Autoradio) ein Wegstreckensignal verwendet werden, um die Zähler zu dekrementieren.

Wird eine Frequenz, über deren PI-Code noch keine Information vorliegt, als aktuell beste Frequenz ermittelt, so wird nach dem Einstellen des Tuners auf diese Frequenz der PI-Code überprüft. Innerhalb eines bestimmten Zeitraumes muß der korrekte PI-Code empfangen werden; andernfalls wird in dem zu dieser Frequenz gehörenden Merker das dritte Bit ("PI-Code unzutreffend") gesetzt und auf die ursprüngliche Abstimmfrequenz zurückgeschaltet.

Damit bei schlechten Empfangsverhältnissen nicht korrekte Frequenzen als solche mit unzutreffendem PI-Code gekennzeichnet werden, wird eine Mindestschwelle für die Qualität eingeführt, ab welcher Frequenzen mit unbekanntem PI-Code eingestellt werden können und auf ihren PI-Code geprüft werden.

Wird bei der eingestellten Frequenz innerhalb von etwa 1 Sekunde kein PI-Code empfangen und hat der zu dieser Frequenz gehörende Zähler in der Alternativsender-Tabelle den Wert Null, so wird dieser Wert auf FFH gesetzt, das dritte Bit des Merkers ("PI-Code unzutreffend") jedoch nicht gesetzt, und es wird auf die ursprüngliche Abstimmfrequenz zurückgeschaltet.

Wird diese Frequenz bei einem erneuten Abstimmversuch wieder als aktuell beste bewertet, so muß ihre Qualität nun, solange der zu ihr gehörende Zähler noch einen Wert größer als Null hat, eine zweite, erhöhte Schwelle überschreiten, damit sie eingestellt und ihr PI-Code geprüft wird. Ist dies der Fall und wird wiederum innerhalb von etwa 1 Sekunde kein korrekter PI-Code empfangen, so wird nun das dritte Bit des Merkers ("PI-Code unzutreffend") gesetzt und auf die ursprüngliche Abstimmfrequenz zurückgeschaltet.

Durch diese Vorgehensweise wird einerseits erreicht, daß Alternativfrequenzen mit korrektem PI-Code schon frühzeitig, d.h. bei noch niedriger Empfangsqualität, aufgeschaltet werden, aber andererseits vermieden, daß nicht korrekte Frequenzen bei schlechten Empfangsverhältnissen fälschlicherweise als solche mit unzutreffendem PI-Code gekennzeichnet werden.

Bei Abstimmfrequenzen mit zutreffendem PI-Code wird vor einem Umschaltversuch anstatt des Zählers ein Wert eingetragen, der repräsentativ für aufgetretene Mehrwegeempfangsstörungen ist. Dieser Wert wird bei der Qualitätsermittlung einer geprüften Frequenz von der gemessenen Qualität abgezogen, da innerhalb der Prüfzeit von einigen Millisekunden keine Aussage über die Mehrwegeempfangsstörungen gemacht werden kann. Da aber für nicht eingestellte Frequenzen dieser für Mehrwegeempfangsstörungen repräsentative Wert veraltet, wird auch er alle 2 bis 3 Sekunden dekrementiert.

Nach Überprüfung aller in Frage kommenden Alternativfrequenzen wird die Alternativsender-Tabelle umsortiert. Bei dieser Umsortierung werden drei Gruppen gebildet. In der ersten Gruppe, die in der Rangfolge am höchsten liegt, sind alle Alternativfrequenzen aufgeführt, bei denen das zweite Bit des Merkers ("PI-Code zutreffend") gesetzt ist, sofern der zugehörige Zähler noch nicht auf Null dekrementiert ist. In der zweiten Gruppe, die in der Rangfolge zwischen der ersten und der dritten liegt, sind alle Alternativfrequenzen aufgeführt, zu denen das zweite oder dritte Bit des Merkers gesetzt oder nicht gesetzt ist, der PI-Code also unbekannt ist oder als unzutreffend erkannt wurde, wobei eine Einordnung in der zweiten Gruppe aber nur dann erfolgt, wenn der zugehörige Zähler bereits auf Null dekrementiert ist.

Die dritte Gruppe schließlich enthält diejenigen Alternativfrequenzen, bei denen das dritte Bit des Merkers gesetzt ist, der PI-Code also als unzutreffend erkannt wurde, und der zugehörige Zähler noch nicht auf Null dekrementiert ist, so daß die Aussage über den Identitätscode als noch aktuell angesehen werden kann.

Innerhalb jeder Gruppe wird die Rangfolge durch den Wert der Qualitätsbewertungs-Information bestimmt. Auf diese Weise wird erreicht, daß Alternativfrequenzen, die mit höherer Wahrscheinlichkeit zu einem guten Empfangsergebnis führen, zuerst geprüft werden.

Nachdem nun die bei dem erfindungsgemäßen Verfahren erfolgende dynamische Verwaltung der Alternativsender-Tabelle beschrieben wurde, sollen anhand der Figuren 4a bis 4d die Kriterien erläutert werden, nach denen entschieden wird, ob ein Versuch der Abstimmung auf eine der Alternativfrequenzen zu erfolgen hat.

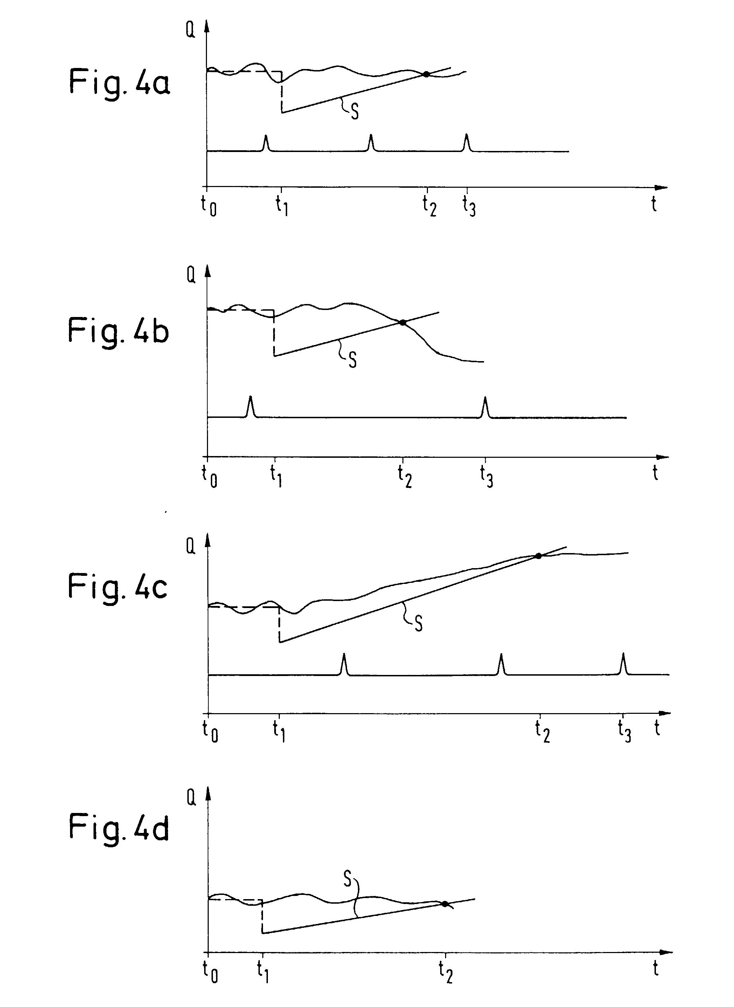

In den Diagrammen der Figuren 4a bis 4d ist auf der Ordinate der Wert Q der Qualitätsbewertungs-Information für den aktuell eingestellten Sender und auf der Abszisse die Zeit t aufgetragen. Der Wert Q ändert sich mit der Zeit t und kann im Mittelwert etwa konstant bleiben (Fig. 4a), abnehmen (Fig. 4b) oder zunehmen (Fig. 4c). Während einer vorbestimmten Zeitspanne von t₀ bis t₁ wird der Mittelwert der Größe Q gebildet. Von diesem Mittelwert wird ein vorbestimmter Betrag in Abzug gebracht. Der so verminderte Mittelwert bildet ab dem Zeitpunkt t₁ einen Schwellwert, mit dem der Wert der Qualitätsbewertungs-Information verglichen wird. Dieser Schwellwert steigt ab dem Zeitpunkt t₁ kontinuierlich mit der Zeit an. Dies ist in den Figuren 4a bis 4d als Gerade S dargestellt. Wie der Vergleich der Figuren 4a und 4d zeigt, ist die Steilheit dieser Geraden S je nach Absolutwert der Qualitätsbewertungs-Information verschieden: Bei guter Qualität erfolgt die Zunahme des Schwellwertes schneller als bei geringer Qualität. In den Figuren 4a bis 4c ist zu beachten, daß der Maßstab inbesondere auf der Zeitachse nicht den tatsächlichen Gegebenheiten entspricht, da sonst die Steigung der Geraden S nicht darstellbar wäre.

Die Umschaltung auf eine der Alternativfrequenzen wird erst möglich, wenn der Wert Q der Qualitätsbewertungs-Information im Zeitpunkt t₂ den Schwellwert S unterschritten hat. Dies kann, wie in Fig. 4a gezeigt, geschehen, indem der Schwellwert S über den Wert Q anwächst, oder aber, wie in Fig. 4b gezeigt, indem der Wert Q unter den Schwellwert S absinkt. Im Falle der Fig. 4c haben sowohl der Wert Q als auch der Schwellwert S eine steigende Tendenz, so daß erst nach einer längeren Zeitspanne im Zeitpunkt t2 die Bedingung erfüllt ist, daß der Wert Q unter den Schwellwert S abgesunken ist. Im Zeitpunkt t₂ erfolgt aber noch keine Umschaltung auf eine Alternativfrequenz. Vielmehr wird erst die Freigabe durch ein anderes Ereignis abgewartet, nämlich das Auftreten einer besonderen Empfangsstörung. In den Figuren 4a, 4b und 4c ist auch das Signal MP (Fig. 1) dargestellt, welches das Auftreten von Mehrwegeempfangsstörungen anzeigt. Diese Störungen treten zwar nur kurzzeitig auf, werden aber als besonders unangenehm empfunden. Die Umschaltung auf diejenige Alternativfrequenz, welche in der Alternativsender-Tabelle den höchsten Rang aufweist, erfolgt also beim Auftreten der ersten Empfangsstörung nach dem Zeitpunkt t2.

Dieses Ereignis ist in den Figuren 4a, 4b und 4c als Zeitpunkt t₃ eingetragen.

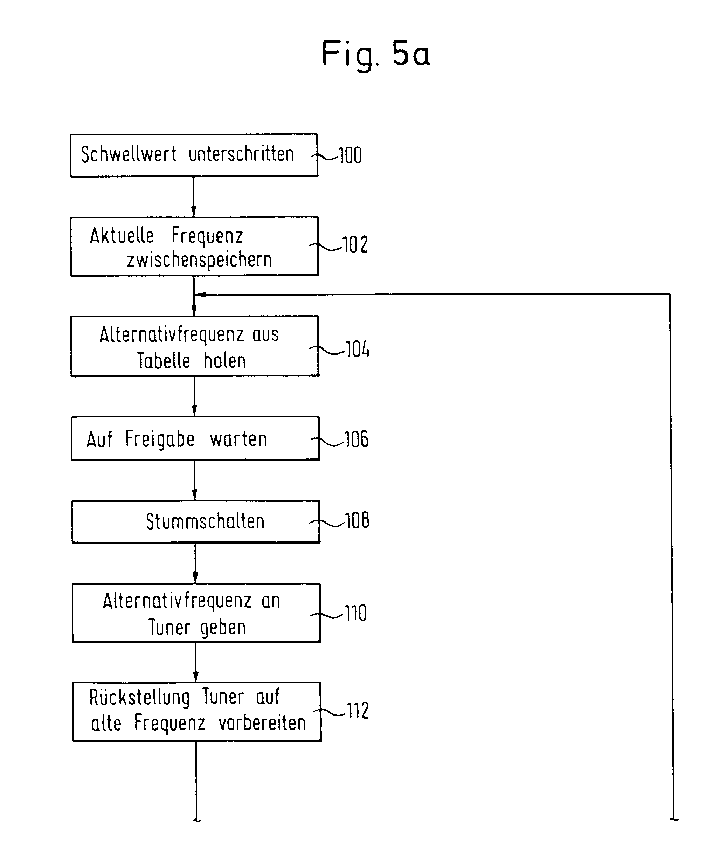

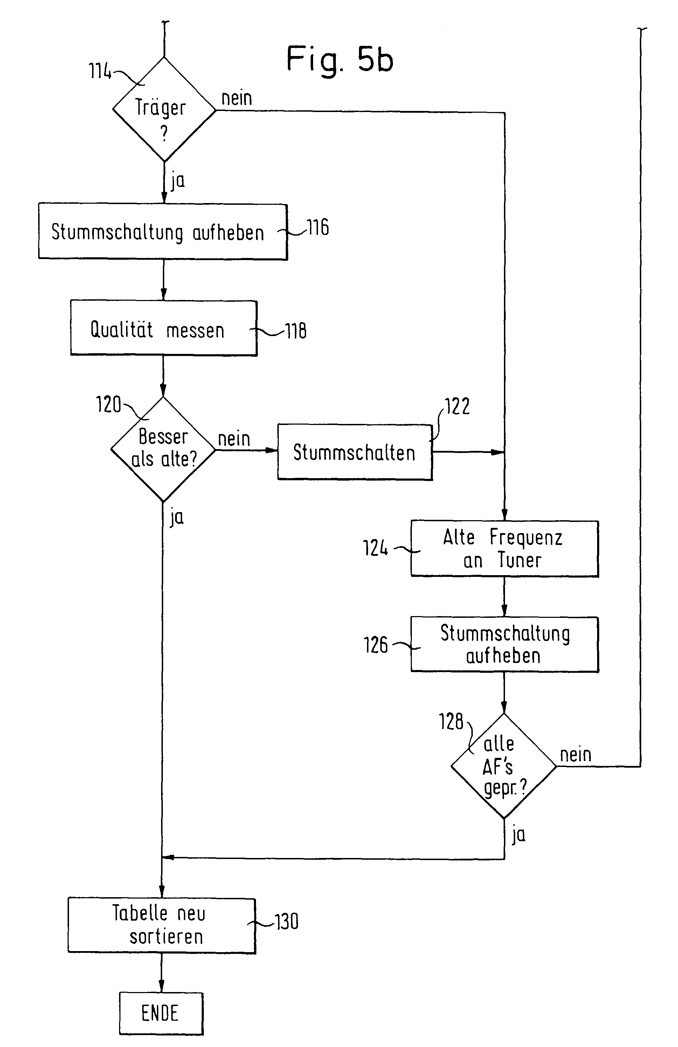

Unter Bezugnahme auf Fig. 5a und 5b wird nun der Vorgang einer Abstimmung auf eine der Alternativfrequenzen näher beschrieben.

Nachdem bei 100 der Schwellwert S unterschritten wurde, wird im Schritt 102 die aktuell eingestellte Empfangsfrequenz zwischengespeichert. Dann wird im Schritt 104 aus der Alternativsender-Tabelle die Alternativfrequenz mit dem höchsten Rang geholt. Im Schritt 106 wird auf die Freigabe, also das Auftreten einer Empfangsstörung, gewartet. Sobald diese eingetreten ist, wird im Schritt 108 eine Stummschaltung vorgenommen, um die Zeitspanne für die Abstimmung auf die neue Abstimmfrequenz zu überbrücken. Um eine eventuell erforderliche Rückstellung auf die zuvor eingestellte Abstimmfrequenz zu beschleunigen, wird im Schritt 112 diese Rückstellung des Tuners auf die alte Abstimmfrequenz vorbereitet.

Im Schritt 114 wird dann geprüft, ob auf der neu eingestellten Frequenz ein Träger empfangen wird. Falls kein Träger empfangen wird, wird die zuvor eingestellte Frequenz im Schritt 124 wieder an den Tuner angelegt, und im Schritt 126 wird die Stummschaltung aufgehoben. Wenn aber im Schritt 114 ein Träger gefunden wird, kann im Schritt 116 die Stummschaltung aufgehoben werden. Anschließend wird im Schritt 118 die Qualität des neuen Senders gemessen. Im Schritt 120 wird dann geprüft, ob die neu eingestellte Alternativfrequenz eine bessere Empfangsqualität als die zuvor eingestellte Frequenz ergibt. Falls die Empfangsqualität besser ist als zuvor, wird die erfolgte Einstellung bestätigt. Andernfalls erfolgt im Schritt 122 eine erneute Stummschaltung, um über die bereits erläuterten Schritte 124 und 126 eine Abstimmung auf die zuvor eingestellte Frequenz vorzunehmen. Wenn im Schritt 128 festgestellt wird, daß noch nicht alle in Frage kommenden Alternativfrequenzen geprüft wurden, erfolgt ein Rücksprung zu Schritt 104; andernfalls und auch dann, wenn im Schritt 120 die Qualität als besser befunden wurde, wird im Schritt 130 die Alternativsender-Tabelle (Fig. 3) neu sortiert, womit der Vorgang beendet ist.

Anschließend wiederholt sich der anhand der Figuren 4a bis 4d beschriebene Vorgang.

## Patentansprüche

1. Verfahren zur Abstimmung eines mikrocomputergesteuerten Rundfunkempfängers auf denjenigen unter mehreren dasselbe Programm ausstrahlenden Sendern, welcher die besten Empfangsqualitätsvoraussetzungen erfüllt, unter Ausnutzung der RDS-Informationen und vorzugsweise unter Verwendung nur eines Empfangsteils; bei welchem:
a) in einem Arbeitsspeicher die aus dem RDS-Datenstrom gewonnenen Daten über Alternativfrequenzen zu dem jeweils eingestellten Sender sortiert in einer Alternativsender-Tabelle abgespeichert werden;
b) bei Abstimmung auf einen Sender, dessen Frequenz gespeichert ist, eine Qualitätsbewertungs-Information in Zuordnung zu dieser Frequenz abgespeichert wird; und
c) bei der Abstimmung auf eine der Alternativfrequenzen die sich aus der jeweils zugehörigen, abgespeicherten Qualitätsbewertungs-Information ergebende Rangfolge berücksichtigt wird;
dadurch gekennzeichnet, daß zur Bestimmung der Rangfolge in der Alternativsender-Tabelle außer der Qualitätsbewertungs-Information eine zeit- und/oder wegstreckenabhängige Aktualititäts-Information bestimmt und ausgewertet wird.

2. Verfahren nach Anspruch 1, dadurch gekennzeichnet, daß in der Alternativsender-Tabelle eine Auswahl getroffen wird, indem wenigstens zwei Gruppen gebildet werden, von denen die erste die in der Rangfolge höherliegenden Alternativfrequenzen beinhaltet, deren Identitätscode bei einer Überprüfung als zutreffend erkannt wurde.

3. Verfahren nach Anspruch 2, dadurch gekennzeichnet, daß bei der Zuordnung der Alternativfrequenzen zu den Gruppen der Alternativsender-Tabelle auch die Aktualitäts-Information berücksichtigt wird.

4. Verfahren nach Anspruch 2 oder 3, dadurch gekennzeichnet, daß die Prüfung der Alternativfrequenzen aus der Alternativsender-Tabelle auf die erste Gruppe beschränkt wird, wenn der gerade eingestellte Sender eine vorbestimmte Mindest-Empfangsqualität aufweist.

5. Verfahren nach Anspruch 4, dadurch gekennzeichnet, daß die Umschaltung auf eine Alternativfrequenz der ersten Gruppe nicht vom Empfang des Identitätscodes abhängig gemacht wird.

6. Verfahren nach einem der Ansprüche 3 bis 5, dadurch gekennzeichnet, daß bei einer Umschaltung auf eine Alternativfrequenz, die nicht zu der ersten Gruppe gehört, keine Stummschaltung während der Prüfung des Identitätscodes erfolgt, wenn bei der letzten Überprüfung dieser Alternativfrequenz ihr Identitätscode als zutreffend befunden wurde.

7. Verfahren nach einem der vorstehenden Ansprüche, dadurch gekennzeichnet, daß eine Überprüfung der aktuell eingestellten Senderfrequenz auf beste Empfangsqualität durch Vergleich mit den Alternativfrequenzen davon abhängig ist, daß die aktuell gemessene Qualitäts-Bewertungsinformation einen Schwellwert unterschreitet, der auf folgende Weise gebildet wird:
a) bei der Einstellung auf diese aktuelle Senderfrequenz wird die gemessene Qualitätsbewertungs-Information über eine gegebene Zeitspanne gemittelt;
b) der so erhaltene Mittelwert wird um eine vorbestimmte Größe vermindert;
c) der so verminderte Mittelwert bildet den Schwellwert, der anschließend mit der abgelaufenen Zeit wieder erhöht wird und nach einigen Minuten wieder den unverminderten Mittelwert erreichen kann.

8. Verfahren nach Anspruch 7, dadurch gekennzeichnet, daß die Erhöhung des verminderten Mittelwertes mit der ablaufenden Zeit um so schneller erfolgt, desto höher die Empfangsqualität des aktuell eingestellten Senders ist.

9. Verfahren nach Anspruch 7 oder 8, dadurch gekennzeichnet, daß die Überprüfung einer Alternativfrequenz erst freigegeben wird, wenn eine momentane Störung der Empfangsqualität festgestellt wird.

10. Verfahren nach einem der Ansprüche 7 bis 9, dadurch gekennzeichnet, daß nach Überprüfung der in Frage kommenden Alternativfrequenzen eine neue Rangfolge der Alternativfrequenzen ermittelt wird und diese Alternativfrequenzen in der Alternativsender-Tabelle gemäß der neuen Rangfolge umsortiert werden.

11. Verfahren nach einem der Ansprüche 3 bis 10, dadurch gekennzeichnet, daß außer der ersten Gruppe eine zweite und eine dritte Gruppe von Alternativsendern gebildet werden, wovon:
a) die zweite Gruppe, die in der Rangfolge höher eingestuft ist als die dritte Gruppe, diejenigen Alternativfrequenzen enthält, deren Identitätscode unbekannt ist oder deren Identitätscode zwar als falsch oder richtig erkannt wurde, aber aufgrund der Aktualitäts-Information als veraltet angesehen wird;
b) die dritte Gruppe diejenigen Alternativfrequenzen enthält, deren Identitätscode als falsch erkannt wurde und aufgrund der Aktualitäts-Information nicht als veraltet angesehen wird.

12. Verfahren zur Abstimmung eines mikrocomputergesteuerten Rundfunkempfängers auf denjenigen unter mehreren dasselbe Programm ausstrahlenden Sendern, welcher die besten Empfangsqualitätsvoraussetzungen erfüllt, unter Ausnutzung der RDS-Informationen und vorzugsweise unter Verwendung nur eines Empfangsteils, wobei in einem Arbeitsspeicher die aus dem RDS-Datenstrom gewonnenen Daten über Alternativfrequenzen zu dem jeweils eingestellten Sender sortiert in einer Alternativsender-Tabelle abgespeichert werden, nach einem der vorstehenden Ansprüche dadurch gekennzeichnet, daß in der Alternativsender-Tabelle alle Alternativfrequenzen, deren Identitätscode bei einer früheren Überprüfung als zutreffend erkannt wurde, markiert werden und beim Umschalten auf eine der so markierten Alternativfrequenzen keine Stummschaltung während einer späteren Überprüfung des Identitätscodes vorgenommen wird.

13. Verfahren nach einem der vorstehenden Ansprüche, dadurch gekennzeichnet, daß eine Qualitätsbewertungs-Information aus der Differenz eines Feldstärke-Anzeigesignals und einem das Störungsmaß anzeigenden Signal gebildet wird.

14. Verfahren nach Anspruch 13, dadurch gekennzeichnet, daß für jede Alternativfrequenz die Ableitung der Qualitätsbewertungs-Information nur dann vorgenommen wird, wenn eine vorbestimmte Mindestfeldstärke vorhanden ist.

## Claims

1. A method of tuning a microcomputer-controlled radio receiver to the one of several transmitters broadcasting the same program which best satisfies the requirements for reception quality, making use of RDS information and preferably using only one receiver section; in which
a) the data obtained from the RDS data stream as to the alternative frequencies of the transmitter currently tuned-in are memorized in a RAM sorted in a table of alternative transmitters;
b) when tuned to a transmitter the frequency of which is memorized, a quality evaluation information is memorized related to this frequency; and
c) upon tuning to each of the alternative frequencies the priority resulting from the corresponding, memorized quality evaluation information is taken into account;
characterized in that to determine the priority in the table of alternative transmitters an actuality information is determined and evaluated which is depending on time and/or distance travelled, in addition to the quality evaluation information.

2. A method according to claim 1, wherein a selection is made in the table of alternative transmitters by at least two groups being formed, of which the first contains the alternative frequencies higher in the priority, the identity code of which was checked to be correct.

3. A method according to claim 2, wherein the actuality information is also taken into account in assigning the alternative frequencies to the groups of the table of alternative transmitters.

4. A method according to claim 2 or 3, wherein checking the alternative frequencies from the table of alternative transmitters is limited to the first group when the currently tuned-in transmitter has a predetermined minimum quality of reception.

5. A method according to claim 4, wherein the changeover to an alternative frequency of the first group is not made dependent on receiving the identity code.

6. A method according to any of the claims 3 to 5, wherein in changing over to an alternative frequency not belonging to the first group no muting occurs during checking the identity code when the identity code of this alternative frequency was found to be correct when last checked.

7. A method according to any of the above claims, wherein checking the currently tuned-in transmitter frequency for best quality of reception by comparison with the alternative frequencies depends on the current measured quality evaluation information falling below a threshold value which is formed in the following way:
a) upon tuning to this current transmitter frequency the measured quality evaluation information is averaged over a given period of time;
b) the resulting average value is diminished by a predetermined amount;
c) this diminished average value forms the threshold value which is subsequently increased with passing time and which may reassume the undiminished average value after a few minutes.

8. A method according to claim 7, wherein increasing the diminished average value with passing time is achieved all the more quicker, the higher the quality of reception of the transmitter currently tuned-in.

9. A method according to claim 7 or 8, wherein checking an alternative frequency is not enabled until a momentary perturbation in the quality of reception is detected.

10. A method according to any of the claims 7 to 9, wherein after checking the alternative frequencies involved a new priority of alternative frequencies is established and these alternative frequencies are resorted in the table of alternative transmitters according to the new priority.

11. A method according to any of the claims 3 to 10, wherein in addition to the first group, a second and a third group of alternative transmitters are formed wherein:
a) the second group is classified higher in the priority than the third group and contains the alternative frequencies whose identity code is unknown or was recognized as being wrong or right but which is considered to be obsolete based on the actuality information;
b) the third group contains the alternative frequencies whose identity code was recognized as being wrong but which is not considered to be obsolete based on the actuality information.

12. A method of tuning a microcomputer-controlled radio receiver to the one of several transmitters broadcasting the same program which best satisfies the requirements for reception quality, making use of RDS information and preferably using only one receiver section; wherein the data obtained from the RDS data stream as to the alternative frequencies of the transmitter currently tuned-in are memorized in a RAM sorted in a table of alternative transmitters, in accordance with any of the preceding claims, characterized in that in the table of alternative transmitters all of the alternative frequencies whose identity code was established as being correct during an earlier checking are flagged and in that no muting is undertaken during a later checking of the identity code when changing over to one of the flagged alternative frequencies.

13. A method according to any of the above claims, wherein a quality evaluation information is formed from the difference of a field intensity indication signal and a signal indicating the rate of noise.

14. A method according to claim 13, wherein the quality evaluation information is derived for each alternative frequency only when a predetermined minimum field intensity exists.

## Revendications

1. Procédé pour accorder un récepteur radio à commande par microprocesseur sur celui parmi plusieurs émetteurs émettant le même programme, qui offre les meilleures conditions de qualité de réception, en utilisant les informations RDS, et de préférence en n'utilisant qu'une seule chaîne de réception; dans lequel:
a) l'on enregistre dans une mémoire vive, de manière ordonnée, les données obtenues à partir du flux de données RDS, sur des fréquences alternatives par rapport à l'émetteur actuel, dans un tableau d'émetteurs alternatifs;
b) lorsqu' on accorde sur un émetteur dont la fréquence est enregistrée, une information de pondération de qualité est enregistrée en association avec cette fréquence ; et
c) lorsqu'on accorde sur une fréquence alternative, l'on tient compte du rang qui résulte de l'information associée et enregistrée de pondération de qualité;
caractérisé en ce que, pour déterminer le rang dans le tableau des émetteurs alternatifs , l'on détermine et exploite, outre l'information de pondération de qualité, une information d'actualité qui dépend du temps et/ou du parcours.

2. Procédé suivant la revendication 1, caractérisé en ce que, dans le tableau d'émetteurs alternatifs, on effectue une sélection en formant au moins deux groupes dans lesquels le premier contient les fréquences alternatives de rang supérieur dont le code d'identité a été reconnu comme correct lors d'une vérification.

3. Procédé suivant la revendication 2, caractérisé en ce que, lors de l'association des fréquences alternatives aux groupes du tableau d'émetteurs alternatifs, l'on tient également compte de l'information d'actualité.

4. Procédé suivant l'une ou l'autre des revendications 2 et 3, caractérisé en ce que la vérification des fréquences alternatives à partir du tableau d'émetteurs alternatifs est limitée au premier groupe lorsque les émetteurs actuels présentent une qualité de réception minimum prédéterminée.

5. Procédé suivant la revendication 4, caractérisé en ce que la commutation sur une fréquence alternative du premier groupe n'est pas rendue dépendante de la réception du code d'identité.

6. Procédé suivant l'une quelconque des revendications 3 à 5, caractérisé en ce que lors d'une commutation sur une fréquence alternative qui n'appartient pas au premier groupe, aucune suppression du son n'est effectuée lors de la vérification du code d'identité si , lors de la dernière vérification de cette fréquence alternative, son code d'identité a été reconnu comme correct.

7. Procédé suivant l'une quelconque des revendications précédentes, caractérisé en ce qu'une vérification de la fréquence actuelle pour déterminer la meilleure qualité de réception par comparaison avec les fréquences alternatives, dépend de ce que l'information de pondération de qualité actuellement mesurée est inférieure à un seuil qui est déterminé de la manière suivante :
a) lorsqu'on accorde sur cette fréquence émetteur actuelle, on fait la moyenne de 1' information de pondération de qualité mesurée pendant un laps de temps déterminé;
b) la moyenne ainsi obtenue est diminuée d'une valeur déterminée;
c) la valeur ainsi diminuée constitue le seuil, qui est ensuite augmenté au fur et à mesure du temps écoulé pour atteindre éventuellement, après quelques minutes, la moyenne non diminuée.

8. Procédé suivant la revendication 7, caractérisé en ce que l'augmentation de la moyenne diminuée au fur et à mesure du temps écoulé s'effectue d'autant plus vite que la qualité de réception de l'émetteur actuel est élevée.

9. Procédé suivant l'une quelconque des revendications 7 et 8, caractérisé en ce que la vérification d'une fréquence alternative n'est permise que lorsqu'on détecte une perturbation momentanée de la qualité de réception.

10. Procédé suivant l'une quelconque des revendications 7 à 9, caractérisé en ce qu'après vérification des fréquences alternatives qui entrent en ligne de compte, un nouveau rang des fréquences alternatives est déterminé, et ces fréquences alternatives sont réordonnées dans le tableau d'émetteurs alternatifs selon le nouveau rang .

11. Procédé suivant l'une quelconque des revendications 3 à 10, caractérisé en ce que l'on forme, additionnellement au premier groupe, un deuxième groupe et un troisième groupe d'émétteurs alternatifs dont:
a) le deuxième groupe, dont le rang est supérieur à celui du troisième groupe, contient les fréquences alternatives dont le code d'identité est inconnu ou dont le code d'identité a été reconnu comme faux ou correct, mais qui est considéré comme périmé sur base de l'information d'actualité;
b) le troisième groupe contient les fréquences alternatives dont le code d'identité a été reconnu comme faux et n'est pas considéré comme périmé sur base de l'information d'actualité.

12. Procédé pour accorder un récepteur radio à commande par microordinateur sur celui parmi plusieurs émetteurs éméttant le même programme qui offre les meilleures conditions de qualité de réception, en utilisant les informations RDS et, de préférence, en n'utilisant qu'une seule chaîne de réception, les informations obtenues à partir du flux de données RDS, sur des fréquences alternatives par rapport à l'émetteur actuel, étant enregistrées de manière ordonnée dans un tableau d'émetteurs alternatifs, selon l'une quelconque des revendications précédentes, caractérisé en ce que, dans le tableau d'émetteurs alternatifs, toutes les fréquences alternatives dont le code d'identité a été reconnu comme correct lors d'une vérification plus récente, sont marquées et, lors de la commutation sur l'une des fréquences alternatives ainsi marquées, aucune suppression du son n'est effectuée lors d'une vérification ultérieure du code d'identité.

13. Procédé suivant l'une quelconque des revendications précédentes, caractérisé en ce qu'une information de pondération de qualité est formée à partir de la différence d'un signal indicateur de l'intensité du champ et d'un signal indicateur du taux de perturbation.

14. Procédé suivant la revendication 13, caractérisé en ce que pour chaque fréquence alternative, la dérivation de l'information de pondération de qualité n'est effectuée que lorsqu'une intensité minimum prédéterminée du champ est présente.
